# EUROPÄISCHE PATENTANMELDUNG

(11) **EP 4 287 791 A1**
(43) Veröffentlichungstag der Anmeldung: **06.12.2023**
(21) Anmeldenummer: 23173704.0
(22) Anmeldetag: 16.05.2023
(51) Int. Cl.: H05K 1/18, H05K 3/28

(54) **LEITERPLATTENBAUGRUPPE MIT EINER EINE AUSBUCHTUNG AUFWEISENDEN ELEKTRISCH ISOLIERENDEN DECKLAGE UND VERFAHREN ZUM HERSTELLEN EINER LEITPLATTENBAUGRUPPE**

(30) Priorität: 30.05.2022 DE 102022113498
(71) Anmelder: Lisa Dräxlmaier GmbH, 84137 Vilsbiburg (DE)
(72) Erfinder: Schafferhans, Stephan, 81477 München (DE)

(57) **Zusammenfassung**

Die Erfindung betrifft eine Leiterplattenbaugruppe (10), umfassend eine Leiterplatte (12) mit zumindest einer elektrisch isolierenden Basislage (14) und einer darauf angeordneten elektrisch leitfähigen Schicht (16); ein auf einer von der Basislage (14) abgewandten Seite der elektrisch leitfähigen Schicht (16) angeordnetes Bauteil (20), das elektrisch leitend mit der elektrisch leitfähigen Schicht (16) verbunden ist; eine elektrisch isolierende Decklage (22), die eine Ausbuchtung (24) in Hochrichtung (z) der Leiterplattenbaugruppe (10) aufweist, in der das (20) Bauteil zwischen der elektrisch leitfähigen Schicht (16) und der Decklage (22) eingehaust ist. Des Weiteren betrifft die Erfindung ein Verfahren zum Herstellen einer derartigen Leiterplattenbaugruppe (10).

## Beschreibung

### Technisches Gebiet

Die vorliegende Erfindung betrifft eine Leiterplattenbaugruppe mit einer eine Ausbuchtung aufweisenden elektrisch isolierenden Decklage sowie ein Verfahren zum Herstellen einer derartigen Leiterplattenbaugruppe.

### Stand der Technik

Bei Leiterplatten erhöht man üblicherweise den Abstand gefährdeter Bauteile von Hochvolt-Potentialen, um den Überschlag der Spannung durch die Luft, also über die sogenannte Luftstrecke, oder das Ausbilden von Kriechstrecken auf Oberflächen, in der Regel der Leiterplatte selbst, zu vermeiden. Beispielsweise kann durch Lackieren der Oberfläche und/oder des betreffenden auf der Leiterplatte kontaktierten Bauteils die Ausbildung von Kriechstrecken reduziert werden. Dies ist ein recht gängiger Prozess, wobei jedoch die Wirksamkeit begrenzt ist, da die Schichtdicke der aufgetragenen Lackierung üblicherweise stark begrenzt ist.

Das Vergießen des Bauteils, beispielsweise mit einem sogenannten Glob Top (also mit einem Verkapselungsmaterial, zum Beispiel ein Vergussmaterial auf Harz-Basis) kann sowohl die Luftstrecke als auch die Kriechstrecke deutlich verringern. Dabei kann jedoch das Problem auftreten, dass die Schichtdicke des Glob Tops auf dem Bauteil einen Mindestwert nicht unterschreiten darf, was in der Fertigung nur schwer exakt zu steuern ist. Außerdem kann es durch thermomechanische Wechselbelastungen (Heiß-Kalt-Zyklen) und unterschiedliche thermische Ausdehnungskoeffizienten zum Ablösen des Glob Tops von der Leiterplatte und somit auch von dem betreffenden Bauteil kommen, wodurch die Isolationsfähigkeit reduziert oder sogar zunichte gemacht wird.

### Beschreibung der Erfindung

Es ist die Aufgabe der Erfindung, eine besonders einfache und zuverlässige elektrische Isolation von einer Leiterplatte mit zumindest einem Bauteil zu ermöglichen.

Diese Aufgabe wird durch die Gegenstände der unabhängigen Ansprüche gelöst. Weitere mögliche Ausgestaltungen der Erfindung sind in den Unteransprüchen, der Beschreibung und den Figuren offenbart.

Die erfindungsgemäße Leiterplattenbaugruppe umfasst eine Leiterplatte mit zumindest einer elektrisch isolierenden Basislage und zumindest einer darauf angeordneten elektrisch leitfähigen Schicht. Des Weiteren umfasst die Leiterplattenbaugruppe ein auf einer von der Basislage abgewandten Seite der elektrisch leitfähigen Schicht angeordnetes Bauteil, das elektrisch leitend mit der elektrisch leitfähigen Schicht verbunden ist. Bei dem Bauteil kann es sich beispielsweise um einen Sensor in Form eines Temperatursensors handeln. Bei dem Bauteil kann es sich um ein elektrisches oder auch um ein elektronisches Bauteil handeln, das elektrisch leitend mit der elektrisch leitfähigen Schicht der Leiterplatte verbunden ist. Das Bauteil kann beispielsweise durch einen Lötvorgang elektrisch leitend mit der elektrisch leitfähigen Schicht verbunden worden sein. Zudem umfasst die Leiterplattenbaugruppe eine elektrisch isolierende Decklage, die wenigstens eine Ausbuchtung in Hochrichtung der Leiterplattenbaugruppe aufweist, in der das Bauteil zwischen der elektrisch leitfähigen Schicht und der Decklage eingehaust ist. Dies kann insbesondere bedeuten, dass das Bauteil zwischen der elektrisch leitfähigen Schicht und der Decklage in alle Raumrichtungen eingehaust ist. Es können auch mehrere Ausbuchtungen mit derselben Deckschicht realisiert werden. Ebenso können auch mehrere Bauteile von einer Ausbuchtung eingehaust werden. Insbesondere kann das Bauteil zwischen der Basislage und der Deckschicht eingehaust sein, um die elektrische Isolation zu gewährleisten. Die elektrisch leitfähige Schicht kann jedoch stellenweise unter der Deckschicht hervorragen, z.B. in Form von Leiterbahnen.

Die elektrisch isolierende Decklage bildet also gemeinsam mit der Leiterplatte eine Art isolierende Hülle um das Bauteil. Bei der Ausbuchtung der elektrischeisolierenden Decklage handelt es sich insbesondere um eine Art Wölbung nach oben in Hochrichtung der Leiterplattenbaugruppe. Die Ausbuchtung kann beispielsweise wie eine Art Kuppel geformt sein. Insbesondere kann die Ausbuchtung der elektrisch isolierenden Decklage an die Form des Bauteils insoweit angepasst sein, dass das Bauteil von der Ausbuchtung problemlos überspannt beziehungsweise eingehaust werden kann. Die elektrisch isolierende Decklage bildet insbesondere eine Art Deckel der Leiterplattenbaugruppe, schließt diese also in Hochrichtung nach oben hin ab. Das elektrisch leitend mit der elektrisch leitfähigen Schicht der Leiterplatte verbundene Bauteil wird also durch die dreidimensional geformte und elektrisch isolierende Decklage eingehaust. Die elektrisch isolierende Decklage kann beispielsweise dafür zunächst vorgeformt und anschließend auf die bestückte Leiterplatte auflaminiert werden. Die Leiterplattenbaugruppe ist dadurch insbesondere auch gut dazu geeignet, in Hochvolt-Umgebungen, beispielsweise bei Spannungen im Bereich von 800 Volt, eingesetzt zu werden.

Durch die erfindungsgemäße Leiterplattenbaugruppe ist es möglich, Bauteile, zum Beispiel in Form von Temperatursensoren, im Hochvolt-Bereich einfach und sicher elektrisch zu isolieren, ohne dabei größere Einschränkungen bezüglich des für die Isolierung notwendigen Bauraums in Kauf nehmen zu müssen. Die Erfindung ermöglicht beispielsweise auch eine Verwendung von flexiblen Leiterplatten, auch ohne lokale Versteifungen, was besonders zur platzsparenden Integration von Temperatursensoren in Ladedosen, Schaltboxen oder Hochvolt-Batterien beiträgt. Die isolierende Decklage kann im Vergleich zu der restlichen Leiterplattenbaugruppe relativ dünn ausgebildet sein, wodurch die zusätzliche thermische Masse auf ein Minimum reduziert werden kann, sodass beispielsweise ein Standard-Bestückungsprozess für Leiterplatten beibehalten werden kann.

Bei der erfindungsgemäßen Leiterplattenbaugruppe ist insbesondere keine zusätzliche Versteifung im Bereich des Bauteils notwendig. Zudem kann die Isolationsfähigkeit beziehungsweise Isolationsleistung ganz einfach gesteuert werden, indem das Material der elektrisch isolierende Decklage und dessen Materialstärke entsprechend gewählt wird. Die elektrisch isolierende Decklage ist derart geformt, dass sich im Bereich des elektrisch zu isolierenden Bauteils eine Kavität befindet, in welcher das Bauteil zwischen der Leiterplatte und der elektrisch isolierenden Decklage eingehaust wird. Die erfindungsgemäße Leiterplattenbaugruppe ermöglicht also eine besonders einfache und zuverlässige elektrische Isolation des auf der Leiterplatte angeordneten Bauteils, insbesondere auch in Hochvolt-Umgebungen.

Eine mögliche Ausgestaltung der Erfindung sieht vor, dass die elektrisch isolierende Decklage einen krempenförmigen Randbereich aufweist, der sich umfangsseitig an einem unteren Bereich der Ausbuchtung der elektrisch isolierenden Decklage anschließt, wobei der krempenförmige Randbereich unmittelbar mit der elektrisch leitfähigen Schicht oder einer weiteren elektrisch isolierenden Decklage der Leiterplatte verbunden ist, die im Bereich des Bauteils ausgespart ist. Der krempenförmige Randbereich der elektrisch isolierenden Deckschicht kann auch direkt mit der Basislage verbunden sein. Mit anderen Worten kann die elektrisch isolierende Decklage hutförmig ausgebildet sein, wobei der krempenförmige Randbereich der elektrisch isolierenden Decklage dazu dient, diese mit der restlichen Leiterplatte zu verbinden, sodass eine besonders zuverlässige Einhausung des betreffenden Bauteils sichergestellt werden kann. An dem beispielsweise kuppelartigen Aufbau der Ausbuchtung schließt sich also umfangsseitig der krempenförmige Randbereich an. Der krempenförmige Randbereich kann insbesondere eben ausgebildet sein, sodass dieser besonders einfach beispielsweise unmittelbar mit der ebenfalls eben ausgebildeten elektrisch leitfähigen Schicht oder mit einer weiteren elektrisch isolierenden Decklage der Leiterplatte, die ebenfalls eben ausgebildet sein kann, verbunden werden kann. Durch diese quasi hutförmige Ausgestaltung der elektrisch isolierenden Decklage ist es auf besonders einfache Weise möglich, diese mit der restlichen Leiterplattenbaugruppe zu verbinden und so für eine zuverlässige Einhausung des Bauteils zu sorgen. Der krempenförmige Randbereich kann so weit ausgedehnt sein, dass er die gesamte Leiterplatte bedeckt. Außerdem kann er - insbesondere im Falle der Bedeckung der gesamten Leiterplatte - auch Aussparungen aufweisen, beispielsweise für andere Bauteile oder zur Kontaktierung der elektrisch leitfähigen Schicht

Eine weitere mögliche Ausgestaltung der Erfindung sieht vor, dass die Ausbuchtung der elektrisch isolierenden Decklage seitlich und oberhalb vom Bauteil beabstandet ist. Die elektrisch isolierende Decklage steht also in keinem direkten Kontakt mit dem elektrisch zu isolierenden Bauteil. Dehnt sich beispielsweise aufgrund von Temperaturänderungen die Leiterplattenbaugruppe aus oder zieht sich zusammen, so besteht mehr Spielraum zwischen dem Bauteil und der Ausbuchtung der elektrisch isolierenden Decklage. Dadurch kann sichergestellt werden, dass es aufgrund von thermisch bedingten Dimensionsänderungen dennoch zu keiner mechanischen Belastung des zu isolierenden Bauteils kommt. Die elektrisch isolierende Decklage stülpt sich also mit ihrer Ausbuchtung quasi glockenförmig über das elektrisch zu isolierende Bauteil, und zwar, ohne dieses zu berühren.

Gemäß einer weiteren möglichen Ausgestaltung der Erfindung ist es vorgesehen, dass die Leiterplatte eine flexible Leiterplatte ist. Die elektrisch isolierende Decklage kann ebenfalls flexibel sein, beispielsweise zumindest im Wesentlichen genauso flexibel wie die flexible Leiterplatte. Die Leiterplatte kann also gemeinsam mit der elektrisch isolierenden Decklage gebogen werden, was eine größere Freiheit bei der Gestaltung und der Anwendung ermöglicht. Die gesamte Leiterplattenbaugruppe kann dadurch beispielsweise auch in sehr kleine Bereiche passen oder in Bereiche passen, die eine ungleichmäßige Form haben, was beispielsweise bei starren Leiterplatten nur schwer oder gar nicht möglich ist.

Eine weitere mögliche Ausgestaltung der Erfindung sieht vor, dass die elektrisch isolierende Decklage aus einer thermisch umgeformten Folie hergestellt ist. Das Folienmaterial kann beispielsweise aus einem thermoplastischen Material bestehen. Die Folie kann beispielsweise aus Polyethylenterephthalat (PET) oder aus Polyethylennaphthalat (PEN) bestehen. Anstelle eines thermoplastischen Materials kann die elektrisch isolierende Decklage beispielsweise auch aus Polyimid bestehen. In letzterem Fall kann man die elektrisch isolierende Decklage z.B. über ein Abscheideverfahren herstellen oder gießen. Durch Herstellung der elektrisch isolierenden Decklage aus der thermisch umgeformten Folie kann die elektrisch isolierende Decklage besonders dünnwandig und flexibel ausgebildet werden. Zudem ist es möglich, die elektrisch isolierende Decklage so in Großserie besonders zuverlässig und kostengünstig herzustellen.

Gemäß einer weiteren möglichen Ausgestaltung der Erfindung ist es vorgesehen, dass die elektrisch isolierende Decklage aus der Basislage geformt ist. Die Ausbuchtung kann z.B. zuerst in einem bestimmten Bereich der Basislage hergestellt werden und danach wird dieser Bereich z.B. so umgeklappt, dass die Ausbuchtung das zumindest eine Bauteil umschließt. Ein Vorteil dabei ist, dass man weniger Einzelteile handhaben muss. Es wäre z.B. möglich, die gesamte Leiterplatte mit der so hergestellten elektrisch isolierenden Decklage abzudecken. Je nach Form der Leiterplatte kann es günstiger sein als die elektrisch isolierende Decklage aus einem separaten Teil herzustellen.

Das erfindungsgemäße Verfahren zum Herstellen der erfindungsgemäßen Leiterplattenbaugruppe oder einer möglichen Ausgestaltung der erfindungsgemäßen Leiterplattenbaugruppe umfasst die folgenden Schritte: Bereitstellen einer Leiterplatte, die zumindest eine elektrisch isolierende Basislage und eine darauf angeordnete elektrisch leitfähige Schicht aufweist; Anordnen eines Bauteils auf einer von der Basislage abgewandten Seite der elektrisch leitfähigen Schicht und elektrisch leitendes Verbinden des Bauteils mit der elektrisch leitfähigen Schicht; Einhausen des auf der elektrisch leitfähigen Schicht angeordneten Bauteils, indem eine elektrisch isolierende Decklage auf der Leiterplatte angeordnet wird, wobei eine in Hochrichtung der Leiterplattenbaugruppe ausgebildete Ausbuchtung der Decklage im Bereich des Bauteils angeordnet wird, hinter das Bauteil zwischen der elektrisch leitfähigen Schicht und der elektrisch isolierenden Decklage eingehaust wird. Das Bauteil kann beispielsweise durch SMT-Bestückung auf der Leiterplatte befestigt und elektrisch leitend mit dieser verbunden werden. Es kann sich also um ein oberflächenmontiertes Bauteil handeln, das zum Beispiel mithilfe lötfähiger Anschlussflächen als eine Art Flachbaugruppe beziehungsweise Flachbauteil direkt auf der Leiterplatte angebracht wird. Vorteile und mögliche Ausgestaltungen der erfindungsgenmäßen Leiterplattenbaugruppe können als Vorteile und mögliche Ausgestaltungen des erfindungsgemäßen Verfahrens und umgekehrt angesehen werden. Das Verfahren kann insbesondere sämtliche Schritte aufweisen, die dazu erforderlich sind, die erfindungsgemäße Leiterplattenbaugruppe oder mögliche Ausgestaltungen der erfindungsgemäßen Leiterplattenbaugruppe herzustellen.

Eine mögliche Ausgestaltung des erfindungsgemäßen Verfahrens sieht vor, dass die elektrisch isolierende Decklage aus einer ebenen Folie hergestellt wird, die unter Ausbildung der Ausbuchtung umgeformt wird. Die ebene Folie kann beispielsweise in Form von Endlosmaterial bereitgestellt und dann passend zu den gewünschten Dimensionen der elektrisch isolierenden Decklage abgelenkt beziehungsweise abgetrennt werden, wonach der abgetrennte Teil der Folie unter Ausbildung der Ausbuchtung umgeformt wird. Dadurch kann die elektrisch isolierende Decklage massenfertigungstauglich besonders einfach hergestellt werden.

Eine weitere mögliche Ausgestaltung des erfindungsgemäßen Verfahrens sieht vor, dass die Ausbuchtung in der elektrisch isolierenden Decklage durch Thermoformen hergestellt wird. Beispielsweise kann die Ausbuchtung in der elektrisch isolierenden Decklage durch einen Tiefziehvorgang in Kombination mit einer entsprechend erforderlichen Wärmeeinwirkung erfolgen. Das Thermoformen zeichnet sich üblicherweise durch relativ geringe Werkzeugkosten aus. Die beim Thermoformen genutzten Werkzeuge sind üblicherweise nur einseitig abbildend, wodurch nur eine Formhälfte beziehungsweise ein Formwerkzeug benötigt wird. Die elektrisch isolierende Decklage wird vor dem Thermoformprozess über ihre Erweichungstemperatur erhitzt und danach wird die erhitzte elektrisch isolierende Decklage beispielsweise mittels Vakuum beziehungsweise Unterdruck an das betreffende Werkzeug gesaugt, infolgedessen die Ausbuchtung ausgebildet wird. Danach wird die fertige elektrisch isolierende Decklage gekühlt, bis die Erstarrungstemperatur erreicht wurde, sodass die elektrisch isolierende Decklage nun formstabil ist und von dem betreffenden Werkzeug gelöst werden kann.

Gemäß einer weiteren möglichen Ausgestaltung des Verfahrens ist es vorgesehen, dass die Ausbuchtung in der elektrisch isolierenden Decklage mittels eines Stempels, insbesondere mittels Tiefziehens, hergestellt wird. Die kann z. B. von Vorteil sein, wen die Ausbuchtung sehr klein ist. Dann kann ein Umformvorgang mit einem Stempel von Vorteil sein.

Eine weitere mögliche Ausgestaltung des erfindungsgemäßen Verfahrens sieht vor, dass die Leiterplatte in einem das Bauteil umgebenden Bereich durch Laminieren mit der elektrisch isolierenden Decklage verbunden wird. Dadurch kann eine besonders zuverlässige und flächige Verbindung zwischen der Leiterplatte und der elektrisch isolierenden Decklage sichergestellt werden. Infolgedessen kann das betreffende Bauteil auch in allen Raumrichtungen besonders zuverlässig eingehaust werden.

In weiterer möglicher Ausgestaltung des Verfahrens ist es vorgesehen, dass die Basislage in einem Bereich unter Ausbildung der zumindest einen Ausbuchtung umgeformt und anschließend umgeklappt wird, um die elektrisch isolierende Decklage herzustellen. Ein Vorteil dieses Vorgehens liegt darin, dass man weniger Einzelteile handhaben muss. Es wäre z.B. möglich, die gesamte Leiterplatte mit der so hergestellten Decklage abzudecken. Je nach Form der Leiterplatte kann es günstiger sein als die elektrisch isolierende Decklage aus einem separaten Teil herzustellen. Die elektrisch isolierende Decklage und die Basislage können z.B. aus derselben Folie geformt werden, d.h. die Basisfolie wird umgeklappt und mit der Ausbuchtung wird das Bauteil eingehaust. Zunächst kann z.B. die Leiterplatte bestückt werden. Danach wird die wenigstens eine Ausbuchtung in der Basislage geformt. Anschließend wird die Basislage umgeklappt und mit der restlichen Basislage (inklusive elektrisch leitfähiger Schichten und evtl. vorhandener weiterer Decklagen zusammen laminiert.

Weitere Vorteile, Merkmale und Einzelheiten der Erfindung können sich aus der nachfolgenden Beschreibung möglicher Ausführungsbeispiele sowie anhand der Zeichnung ergeben. Die vorstehend in der Beschreibung genannten Merkmale und Merkmalskombinationen sowie die nachfolgend in der Figurenbeschreibung und/oder in den Figuren allein gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

### Kurze Figurenbeschreibung

Die Zeichnung zeigt in:
- Fig. 1: eine schematische Seitenansicht einer Leiterplattenbaugruppe, die ein auf einer Leiterplatte angeordnetes Bauteil aufweist, das von einer elektrisch isolierenden Decklage, die eine Ausbuchtung aufweist, eingehaust wird;
- Fig. 2: eine weitere mögliche Ausgestaltung der Leiterplattenbaugruppe;
- Fig. 3: eine schematische Darstellung von Herstellungsschritten zum Herstellen der in Fig. 2 gezeigten Ausführungsform der Leiterplattenbaugruppe.

Gleiche oder funktionsgleiche Elemente sind in den Figuren mit gleichen Bezugszeichen versehen worden.

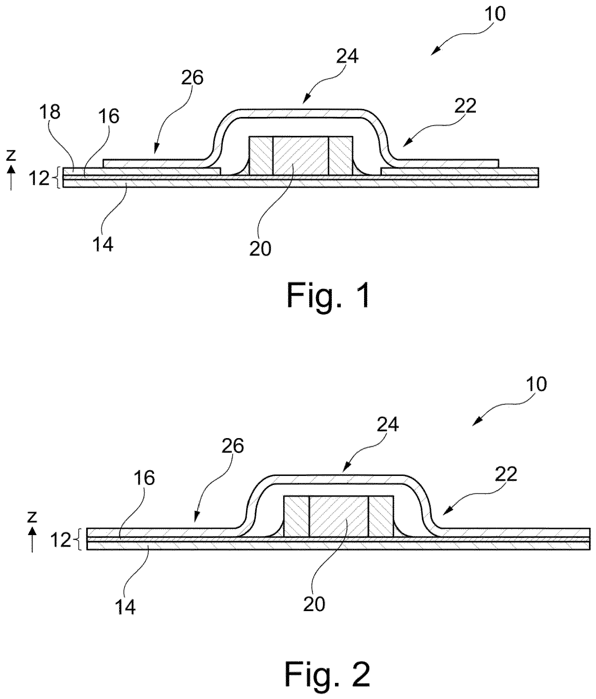

Eine Leiterplattenbaugruppe 10 ist in einer schematischen Seitenansicht in Fig. 1 gezeigt. Die Leiterplattenbaugruppe 10 umfasst eine Leiterplatte 12, die eine elektrisch isolierende Basislage 14 und eine darauf angeordnete elektrisch leitfähige Schicht 16 aufweist. Des Weiteren umfasst die Leiterplatte 12 noch eine elektrisch isolierende Decklage 18, die rund um einen Bereich, in dem ein Bauteil 20 angeordnet ist, ausgespart ist und somit die elektrisch leitfähige Schicht 16 rund um den Bereich des Bauteils 20 freigibt. Wie zu erkennen, ist das Bauteil 20 auf einer von der Basislage 14 abgewandten Seite der elektrisch leitfähigen Schicht 16 angeordnet, wobei dieses elektrisch leitend mit der elektrisch leitfähigen Schicht 16 verbunden ist.

Des Weiteren umfasst die Leiterplattenbaugruppe 10 eine elektrisch isolierende Decklage 22, die eine Ausbuchtung 24 in Hochrichtung z der Leiterplattenbaugruppe 10 aufweist, in der das Bauteil 20 zwischen der elektrisch leitfähigen Schicht 16 und der Decklage 22 eingehaust ist.

Die elektrisch isolierende Decklage 22 weist einen krempenförmigen Randbereich 26 auf, der sich umfangsseitig an einem unteren Bereich der Ausbuchtung 24 anschließt. Der krempenförmige Randbereich 26 ist mit der elektrisch isolierenden Decklage 18 der Leiterplatte 12 verbunden. Wie zu erkennen, ist die Ausbuchtung 24 der elektrisch isolierenden Decklage 22 seitlich und oberhalb vom Bauteil 20 beabstandet. Die Ausbuchtung 24 umspannt das Bauteil 20 also kuppelartig beziehungsweise glockenartig, und zwar ohne das Bauteil 20 zu berühren. Bei der Leiterplatte 12 kann es sich um eine flexible Leiterplatte handeln, wobei die elektrisch isolierende Decklage 22 ebenfalls entsprechend flexibel wie die Leiterplatte 12 ausgebildet sein kann.

Die elektrisch isolierende Decklage 24 kann beispielsweise aus einer thermisch umgeformten Folie hergestellt sein. Bei dem Bauteil 20 kann es sich beispielsweise um einen Temperatursensor handeln.

In Fig. 2 ist eine weitere mögliche Ausgestaltung der Leiterplattenbaugruppe 10 in einer schematischen Seitenansicht gezeigt. Die hier gezeigte Ausführungsform unterscheidet sich von der in Fig. 1 gezeigten Ausführungsform dadurch, dass die Leiterplatte 12 nicht mehr zusätzlich ihre eigene elektrisch isolierende Decklage 18 aufweist. Die elektrisch isolierende Decklage 22 ist in diesem Fall unmittelbar mit der elektrisch leitenden Schicht 16 verbunden.

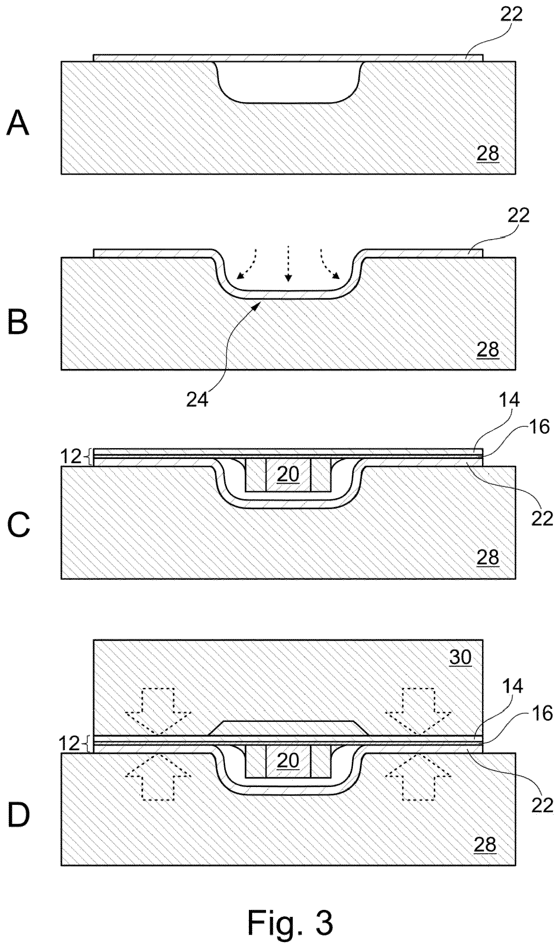

In Fig. 3 ist schematisch eine Abfolge von Verfahrensschritten A bis D dargestellt, die zum Herstellen der Leiterplattenbaugruppe 10 gemäß der in Fig. 2 gezeigten Ausführungsform dienen. Zunächst wird die noch nicht umgeformte elektrisch isolierende Decklage 22 auf einem Werkzeug 28 angeordnet. Die elektrisch isolierende Decklage 22 kann beispielsweise aus einer thermoplastischen ebenen Folie hergestellt werden. Nachdem die noch nicht umgeformte elektrisch isolierende Decklage 22 auf dem Werkstück 28 angeordnet wurde, wird diese durch Thermoformen unter Ausbildung der Ausbuchtung 24 hergestellt. Dafür kann an dem Werkzeug 28 beispielsweise ein Unterdruck angelegt werden, infolgedessen die elektrisch isolierende Decklage 22 entsprechend an das Werkzeug 28 herangesaugt wird. Vor diesem Schritt kann die noch nicht umgeformte elektrisch leitfähige Schicht 22 über ihre Erweichungstemperatur erhitzt werden. Danach wird die aufgeheizte Decklage 22 an das Werkzeug 28 unter Ausbildung der Ausbuchtung 24 thermisch umgeformt. Danach kann die umgeformte elektrisch isolierende Decklage beispielsweise über Gebläse gekühlt werden, bis die elektrisch isolierende Decklage ihre Erstarrungstemperatur erreicht hat.

In einem nächsten Schritt wird die zumindest schon teilweise bestückte Leiterplatte 12, auf der das Bauteil 20 schon aufgelötet wurde, relativ zur thermogeformten Decklage 22 positioniert. In einem anschließenden Laminierprozess wird dann die zumindest teilweise bestückte Leiterplatte 12 mit der thermogeformten elektrisch isolierenden Decklage 12 verbunden. Dafür kann, wie hier schematisch angedeutet, ein weiteres Werkzeug 30 beispielsweise verwendet werden, mit dem Druck auf die Leiterplattenbaugruppe 10 ausgeübt wird, wobei die Werkzeuge 28, 30 zudem dazu verwendet werden können, während des Laminierprozesses die entsprechenden Elemente der Leiterplattenbaugruppe 10 zu erwärmen.

### BEZUGSZEICHENLISTE

- 10: Leiterplattenbaugruppe
- 12: Leiterplatte
- 14: elektrisch isolierende Basislage der Leiterplatte
- 16: elektrisch leitfähige Schicht der Leiterplatte
- 18: elektrisch isolierende Decklage der Leiterplatte
- 20: Bauteil
- 22: elektrisch isolierende Decklage
- 24: Ausbuchtung der elektrisch isolierende Decklage
- 26: krempenförmiger Randbereich der elektrisch isolierenden Decklage
- 28: Werkzeug
- 30: Werkzeug
- A-D: Verfahrensschritte
- z: Hochrichtung der Leiterplattenbaugruppe

## Patentansprüche

1. Leiterplattenbaugruppe (10), umfassend:
- eine Leiterplatte (12) mit zumindest einer elektrisch isolierenden Basislage (14) und zumindest einer darauf angeordneten elektrisch leitfähigen Schicht (16);
- zumindest ein auf einer von der Basislage (14) abgewandten Seite der elektrisch leitfähigen Schicht (16) angeordnetes Bauteil (20), das elektrisch leitend mit der elektrisch leitfähigen Schicht (16) verbunden ist;
- eine elektrisch isolierende Decklage (22), die zumindest eine Ausbuchtung (24) in Hochrichtung (z) der Leiterplattenbaugruppe (10) aufweist, in der das (20) Bauteil zwischen der elektrisch leitfähigen Schicht (16) oder der Basislage (14) und der Decklage (22) eingehaust ist.

2. Leiterplattenbaugruppe (10) nach Anspruch 1,
**dadurch gekennzeichnet, dass**
die elektrisch isolierende Decklage (22) einen krempenförmigen Randbereich (26) aufweist, der sich umfangsseitig an einem unteren Bereich die Ausbuchtung (24) anschließt, wobei der krempenförmige Randbereich (26) unmittelbar mit der elektrisch leitfähigen Schicht (16), der Basislage (14) oder einer elektrisch isolierenden Decklage (18) der Leiterplatte (12) verbunden ist, die im Bereich des Bauteils (20) ausgespart ist.

3. Leiterplattenbaugruppe (10) nach einem der vorhergehenden Ansprüche,
**dadurch gekennzeichnet, dass**
die Ausbuchtung (24) der elektrisch isolierenden Decklage (22) seitlich und oberhalb vom Bauteil (20) beabstandet ist.

4. Leiterplattenbaugruppe (10) nach einem der vorhergehenden Ansprüche,
**dadurch gekennzeichnet, dass**
die Leiterplatte (12) eine flexible Leiterplatte ist.

5. Leiterplattenbaugruppe (10) nach einem der vorhergehenden Ansprüche,
**dadurch gekennzeichnet, dass**
die elektrisch isolierende Decklage (22) aus einer thermisch umgeformten Folie hergestellt ist.

6. Leiterplattenbaugruppe (10) nach einem der vorhergehenden Ansprüche,
**dadurch gekennzeichnet, dass**
die elektrisch isolierende Decklage (22) aus der Basislage (14) geformt ist.

7. Leiterplattenbaugruppe (10) nach einem der vorhergehenden Ansprüche,
**dadurch gekennzeichnet, dass**
das Bauteil ein Sensor ist.

8. Verfahren zum Herstellen einer Leiterplattenbaugruppe (10), umfassend die Schritte:
- Bereitstellen einer Leitplatte (12), die zumindest eine elektrisch isolierende Basislage (14) und zumindest eine darauf angeordnete elektrisch leitfähige Schicht (16) aufweist;
- Anordnen zumindest eines Bauteils (20) auf einer von der Basislage (14) abgewandten Seite der elektrisch leitfähigen Schicht (16) und elektrisch leitendendes Verbinden des Bauteils (20) mit der elektrisch leitfähigen Schicht (16);
- Einhausen des auf der elektrisch leitfähigen Schicht (16) angeordneten Bauteils (20), indem eine elektrisch isolierende Decklage (22) auf der Leiterplatte (12) angeordnet wird, wobei eine in Hochrichtung (z) der Leiterplattenbaugruppe (10) ausgebildete Ausbuchtung (24) der Decklage (22) im Bereich des Bauteils (20) angeordnet wird, in der das Bauteil (20) zwischen der elektrisch leitfähigen Schicht (16) oder der Basislage (14) und der Decklage (22) eingehaust wird.

9. Verfahren nach Anspruch 8,
**dadurch gekennzeichnet, dass**
die elektrisch isolierende Decklage (22) aus einer ebenen Folie hergestellt wird, die unter Ausbildung der Ausbuchtung (24) umgeformt wird.

10. Verfahren nach Anspruch 8 oder 9,
**dadurch gekennzeichnet, dass**
die Ausbuchtung (24) in der elektrisch isolierenden Decklage (22) durch Thermoformen hergestellt wird.

11. Verfahren nach Anspruch 8 oder 9,
**dadurch gekennzeichnet, dass**
die Ausbuchtung (24) in der elektrisch isolierenden Decklage (22) mittels eines Stempels, insbesondere mittels Tiefziehens, erfolgt.

12. Verfahren nach einem der Ansprüche 8 bis 11,
**dadurch gekennzeichnet, dass**
die Leiterplatte (12) in einem das Bauteil (20) umgebenden Bereich durch Laminieren mit der elektrisch isolierenden Decklage (22) verbunden wird.

13. Verfahren nach einem der Ansprüche 7 bis 11,
**dadurch gekennzeichnet, dass**
die Basislage (14) in einem Bereich unter Ausbildung der zumindest einen Ausbuchtung (24) umgeformt und anschließend umgeklappt wird, um die elektrisch isolierende Decklage (22) herzustellen.
